# EUROPEAN PATENT APPLICATION

(11) **EP 4 564 628 A1**
(43) Date of publication of application: **04.06.2025**
(21) Application number: 23213501.2
(22) Date of filing: 30.11.2023
(51) Int. Cl.: H02H 3/16, H02H 3/04, B60L 3/00

(54) **PROTECTION SYSTEM FOR ISOLATED TERRA BIPOLAR DC SYSTEM**

(71) Applicant: Chargeco Holding B.V., 5503 LP Veldhoven (NL)
(72) Inventor: GERRITS, Thomas, Veldhoven (NL); TORRI, Paulo Jose, Veldhoven (NL)
(74) Representative: DeltaPatents B.V.

(57) **Abstract**

A protection system 110 and method are provided for a DC system, wherein the DC system is an isolated terra bipolar DC system comprising a positive conductor, a negative conductor, and a midpoint conductor, wherein the DC system is designed to be symmetric around a midpoint at the midpoint conductor, wherein the protection system comprises a predetermined impedance 120 arranged between the midpoint conductor and protective earth, a current measurement circuit 130-134 configured to determine a magnitude of a current flowing through the predetermined impedance, and a fault detection circuit 140 configured to compare the magnitude of the current against a threshold, optionally to compensate for the current using a current source 160, and to trigger a fault action if the magnitude of the current exceeds the threshold. By measuring the current, and thereby fault current transients, instead of DC voltage transients, the protection system may allow faster detection than the prior art, e.g., IMDs. Furthermore, by way of the predetermined impedance, post-fault currents may be limited to acceptable levels and thereby avert destructive consequences.

## Description

### TECHNICAL FIELD

The invention relates to a protection system and method for a DC system, wherein the DC system is an isolated terra bipolar DC system comprising a positive conductor, a negative conductor, and a midpoint conductor, wherein the DC system is designed to be symmetric around a midpoint at the midpoint conductor.

### BACKGROUND

In the realms of sustainable and durable energy, power conversion and transportation circuits are increasingly delivering higher power levels. Consequently, the complexity of these systems and the number of interconnected ports is also on the rise. These increases may necessitate the implementation of robust protection mechanisms to ensure safe circuit operation.

To address the challenge of higher power levels, system voltages are increased to keep current levels manageable. This practice is prevalent in various applications, including electric vehicle (EV) DC systems, EV supply equipment (EVSE or chargers), stationary durable energy resources (DERs) like batteries, solar panels, and electrolysers, and in local micro-grid systems that interconnect AC grids, EVSEs and DERs together.

A critical requirement across these applications is the necessity for the DC section to be an Isolated Terra (IT) circuit. This configuration is essential for human protection and permits the occurrence of a single fault without destructive outcomes. Despite the DC system facilitating easier interconnection and power transfer among assets (e.g., batteries, solar panels, motor drives, DC grids), DC systems present significant protection challenges. One potential solution for increasing the DC system's voltage is the adoption of a symmetric, bipolar configuration.

There exist current industry standards for Insulation Monitoring Devices (IMDs) in IT circuits, such as IEC 61557-8 and, in the field of conductive EV charging, IEC 61851 or UL equivalent UL2202 and UL2231. These standards reveal the limitations of IMDs in Megawatt Charging Standard (MCS) applications. Further elaboration on this is provided in, for example, the 'CharIN Whitepaper on Megawatt Charging System' (https://www.charin.global/media/pages/technology/knowledge-base/c708ba3361-1670238823/whitepaper megawatt charging system 1.0.pdf), from which the following conclusions may be drawn:
- An IMD can only detect the presence of a fault in the IT-circuit but cannot pinpoint its location.
- The normally continued operation of an IT-circuit after occurrence of the first fault is not allowed, nor used in conductive charging nor in PV installations. The combined requirement in the relevant standards of an IT-circuit (galvanic isolation mandatory) of stopping it after a first fault (IMD) makes the system expensive and more complex without the advantages of continued operation.
- The periodic measure-process-act principle of IMD detection introduces a significant delay between fault occurrence and system safety.
- A symmetrically forced DC system minimizes potential discharge current from the Y-capacitance between the DC+ or DC- pole and PE, thereby reducing the system's hazard level.
- An IMD's capability to measure total Y-capacitance in an IT-circuit is limited, and this measurement does not provide any evaluation parameters for isolation properties of the system.
- The intended touch-safe protection is not sustainable for increased DC system voltages or power levels, or their combinations beyond the MCS operational range. This also applies to symmetric DC circuits.

The complexity of high-power systems is partly due to their physical size, affecting components such as EV batteries, (traction) machines, charger converter isolation, and cabling in DER or infrastructure systems. These components inadvertently introduce stray capacitance. Furthermore, each product and the system collectively must adhere to EMC standard limits to ensure interoperable use, necessitating additional Y-capacitance that exacerbates the issue.

Examples of relevant IT-circuit-based systems include bipolar and unipolar DC systems (such as HVDC infrastructure or LVDC equivalent and chargers or PV installations, respectively), and split-phase electric power AC systems (like the 240 V AC system with two 120 V AC phases in anti-phase, commonly used in the USA).

It would be desirable to obtain a protection system which can facilitate safe operation of an IT circuit with a symmetric bipolar DC section, for example by being able to monitor the safe operation and to trigger a fault action upon detecting a fault.

### SUMMARY

In accordance with a first aspect of the invention, a protection system is provided for a DC system, wherein the DC system is an isolated terra bipolar DC system comprising a positive conductor, a negative conductor, and a midpoint conductor, wherein the DC system is designed to be symmetric around a midpoint at the midpoint conductor, wherein the protection system comprises:
- a predetermined impedance arranged between the midpoint conductor and protective earth;
- a current measurement circuit configured to determine a magnitude of a current flowing through at least a resistive part of the predetermined impedance;
- a fault detection circuit configured to compare the magnitude of the current against a threshold, and to trigger a fault action if the magnitude of the current exceeds the threshold.

In accordance with a further aspect of the invention, a protection method is provided for a DC system, wherein the DC system is an isolated terra bipolar DC system comprising a positive conductor, a negative conductor, and a midpoint conductor, wherein the DC system is designed to be symmetric around a midpoint at the midpoint conductor, wherein the protection method comprises:
- arranging a predetermined impedance between the midpoint conductor and protective earth;
and during operation of the DC system:
- determining a current flowing through at least a resistive part of the predetermined impedance;
- determining a magnitude of the current;
- comparing the magnitude of the current against a threshold; and
- triggering a fault action if the magnitude of the current exceeds the threshold.

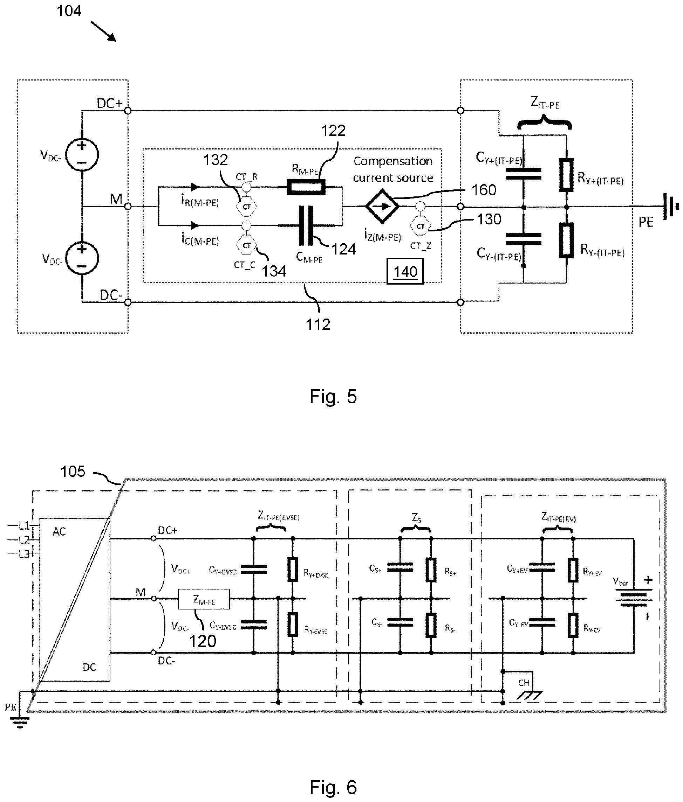

The above measures involve providing a predetermined impedance, i.e., an impedance with a predetermined value, between the DC system's midpoint and Protective Earth (PE) and monitoring the magnitude, and optionally also the direction, of the current flowing through the predetermined impedance. Thereby, the IT circuit may be effectively converted a ZM-S earthing system analogous to IEC terminology (IEC 60364) as also explained elsewhere in this specification with reference to Fig. 5.

The operation of the protection system may be explained as follows. When a balanced DC section (this DC section also being referred to as DC system elsewhere) of a circuit experiences a fault condition to protective earth (PE), this typically causes an imbalance in the operation of the DC section, which in turn causes a current to flow through the impedance. By measuring the current, such imbalances may be detected. In particular, by measuring the magnitude of the current and comparing it against a threshold, the severity of the fault may be determined. This may enable the protection system to trigger fault actions, such as an external alert or triggering a circuit breaker. In particular, the current through a resistive part of the impedance, e.g., a resistance, may be measured. Advantageously, by measuring the current, and thereby fault current transients instead of DC voltage transients, the protection system may be capable of faster detection than prior art IMDs, as small fault currents, that may be accurately measured by an appropriate current measurement circuit, such as a current transducer, typically only cause a slow rate of voltage change over the impedance's capacitance and thus require significantly more time to reliably measure. Furthermore, the protection system may allow the DC system to continue operating after a single fault. Namely, by being able to quickly and accurately measure small fault currents, the protection system may initially only trigger an alert, e.g., when the fault current exceeds a first threshold, and only proceed to trigger a circuit breaker or in another manner stop operations if the fault current exceeds a second, higher, threshold. This level of discrimination is typically not offered by the aforementioned prior art IMDs as these are incapable of determining where in the IT circuit the fault is caused. Therefore, a single fault must already lead to a full stop of the system. Additionally, slow reaction time of an IMD may necessitate stopping operation out of precaution. Moreover, the chosen value of the predetermined impedance may limit post-fault current to acceptable levels and thereby avert destructive consequences.

In an embodiment, the current measurement circuit is further configured to determine a direction of the current, and the fault detection circuit is configured to, on the basis of the direction, determine a fault location of an isolation fault with respect to the protective earth. For example, for DC faults, the fault location may be indicative of whether the isolation fault is between the positive conductor and the protective earth or between the negative conductor and the protective earth. Namely, by determining the direction of the fault current, the type of imbalance, and thereby the location of the fault, being either in the V_{DC+} or V_{DC-} section of the DC system, may be determined. It is noted that AC faults may similarly cause an imbalance in the operation of the DC system, and based the direction of the current, it may be concluded where such an AC fault is located. It is further noted that in order to distinguish between AC and DC faults, the protection system may detect AC currents flowing through the impedance, and in particular flowing through a capacitive part of the impedance, as such AC currents may be indicative of a fault being an AC fault. Thereby, the protection system enables fault detection, which may allow a fault to be faster detected and resolved.

In an embodiment, the fault action comprises one or more of:
- triggering a circuit braker;
- sending an alert; and
- activating an auxiliary protection system.

In an embodiment, the impedance comprises or consists of a parallel arrangement of a predetermined resistance and a predetermined capacitance. The current measurement circuit may measure at least the current through the predetermined resistance to detect DC and AC faults and the current level (which may also be referred to as an 'absolute limiting current level' due to the resistance imposing an absolute limit on this current). The capacitance may steer high frequency currents created by electromagnetic interference away from the resistance and may act as a filter to avoid or reduce the chance of the fault detection circuit erroneously triggering. In some embodiments, also the current through the predetermined capacitance may be measured, or otherwise computed, to detect AC currents that exhibit transient behaviour and which may be the result of stray effects and/or current mode effects. The fault detection circuit may detect and analyse AC currents through the capacitance to determine that a detected fault is an AC fault at an AC side of the IT circuit.

In an embodiment the current measurement circuit comprise at least two of: a current transducer arranged in a current path of the predetermined resistance, a current transducer arranged in a current path of the predetermined capacitance, and a current transducer arranged in a common current path of the predetermined resistance and the predetermined capacitance. Current transducers have been found to be well suited to quickly and accurately measure fault currents. Since the current in the common current path corresponds to the sum of the current through the predetermined resistance and the current through the predetermined capacitance, it is possible to determine, using at least two of said current transducers, the third current by either addition or subtraction of the other two currents. Advantageously, two current transducers may suffice to be able to determine all three currents.

In an embodiment, the fault detection circuit is configured to determine a resistance R_{fault} of an isolation fault between on the one hand the positive conductor or the negative conductor and on the other hand protective earth by solving for R_{fault} in the formula i_{R(M-PE)} = V_{DC}/(R_{fault} + R_{M-PE}), where i_{R(M-PE)} is a value of a measured current through the predetermined resistance, R_{(M-PE)} is a value of the predetermined resistance, and V_{DC} is a DC voltage at the respective positive or negative conductor.

In an embodiment, the predetermined resistance is chosen from a range of 10-1000 Ω.

In an embodiment, the predetermined capacitance is chosen from a range of 5-50 µF.

In an embodiment, the protection system further comprises a current source arranged in a current path of the predetermined impedance, wherein the fault detection circuit is configured to control the current source to reduce the current flowing through the predetermined impedance. This way, current flowing through the predetermined impedance, for example due to unintended current mode (CM) stray current during normal operation or a fault current in case of a failure (e.g., full short or reduced IT-PE impedance below a defined threshold), may be compensated. In some examples, the fault detection circuit may be configured to control the current source to regularize the current to remain below a threshold. The compensation of unintended CM stray current may be especially relevant for, e.g., marine applications, where such currents can lead to corrosion in metal parts of ships or underwater structures. In these environments, stray currents can accelerate galvanic corrosion. This can compromise the structural integrity of hulls, propellers, and other metal components. Additionally, in sensitive marine equipment like sonar, navigation systems, and communication devices, CM stray currents can cause electromagnetic interference, leading to malfunctions or inaccurate readings. This interference is particularly problematic in precision instruments, where even slight deviations can lead to significant errors. By being able to compensate for such CM stray currents, these negative effects may be mitigated.

In an embodiment, the DC system comprises a positive conductor, a negative conductor, and a midpoint conductor, wherein the DC system is designed to be symmetric around a midpoint at the midpoint conductor, wherein the DC system comprises the protection system as described elsewhere in this specification.

In an embodiment, the DC system is designed to comprise a system resistance between i) each one of the positive conductor and the negative conductor and ii) protective earth, wherein the system resistance is within a range of 0.1-20 MΩ.

In an embodiment, the DC system is designed to comprise a system capacitance between i) each one of the positive conductor and the negative conductor and ii) protective earth, wherein the system capacitance is within a range of 100-2000 µF.

In an embodiment, the DC system is or comprises a DC charger, for example an EV DC charger.

In an embodiment, the DC system is configured to operate as a symmetrical DC system at a maximum DC voltage at or above 920 V.

In an embodiment, the DC system comprises multiple instances of the protection system. The DC system may thus comprise several protection systems which may together provide the protection functionality in a decentralized manner.

It will be appreciated by those skilled in the art that two or more of the above-mentioned embodiments, implementations, and/or aspects of the invention may be combined in any way deemed useful.

Modifications and variations of any one of the systems or methods, which correspond to the described modifications and variations of another one of these systems or methods, may be carried out by a person skilled in the art on the basis of the present description.

### BRIEF DESCRIPTION OF THE DRAWINGS

These and other aspects of the invention are apparent from and will be elucidated with reference to the embodiments described hereinafter. In the drawings,
Fig. 1 shows an IT circuit as a composition of AC and/or DC components;
Fig. 2 shows a basic example of an IT circuit in form of EVSE-EV combination with a symmetric DC section with Voc+ = V_{DC-};
Fig. 3 shows a basic ZM circuit diagram indicating the equivalent overall impedance with respect to PE of an IT circuit, Z_{IT-PE}, and the added impedance, Z_{M-PE}, by which the circuit arrangement is changed to an ZM-S earthing system;
Fig. 4 shows sensors and components details of the ZM-S earthing system;
Fig. 5 shows the ZM-S earthing system with a compensation current source;
Fig. 6 shows a ZM equivalent to the IT circuit in Fig. 2;
Fig. 7 shows examples of fault locations that may be detected by the fault detection circuit, wherein R_{fault1} to R_{fault3} are the values of the resistance at the respective fault locations;
Fig. 8 show an example of an insulation fault between a positive pole and protective earth, showing a main fault current path and a detection fault current path;
Fig. 9 illustrates the circuit used for the calculation of the fault resistance;
Fig. 10 shows additional fault locations which may be detected by the fault detection circuit;
Fig. 11 shows a protection method for a DC system; and
Fig. 12 shows a non-transitory computer-readable medium comprising data.

### Reference signs list

The following list of references and abbreviations is provided for facilitating the interpretation of the drawings and shall not be construed as limiting the claims.
- 100, 106, 109: isolated terra (IT) circuit
- 101 - 105: DC section/system
- 107, 108: DC section/system
- 110, 112: protection system
- 120: predetermined impedance
- 122: predetermined resistance
- 124: predetermined capacitance
- 130-134: current transducer
- 140: fault detection circuit
- 150: detection main current path
- 152: detection fault current path
- 160: current source

- 200: protection method for a symmetric, isolated terra bipolar DC system
- 210: providing predetermined impedance
- 220: operation of the DC system
- 230: determining current flowing through predetermined impedance
- 240: determining magnitude of current
- 250: comparing magnitude of current against threshold
- 260: triggering fault action

- 300: non-transitory computer-readable medium
- 310: data

### DESCRIPTION OF EMBODIMENTS

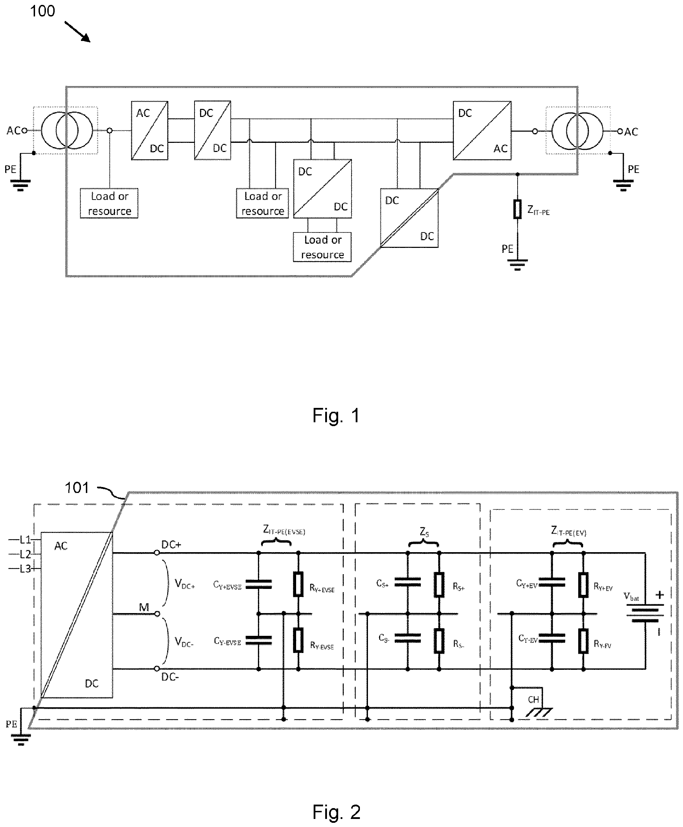

**Fig. 1** shows a generic isolated terra (IT) circuit 100. The IT circuit may comprise converters that have a defined minimum resultant impedance Z_{IT-PE} with respect to protective earth (PE) and converters that may or may not be isolated and therefore their respective outputs may be included (non-isolated) or excluded (isolated) from the IT circuit. The overall IT circuit has a defined minimum resultant impedance (ZIT-PE) with respect to PE. This circuit, which may be considered to 'float', may represent anything from an AA size battery connected to an LED up to a DC grid with numerous resources and loads connected to multiple AC grid points using galvanically isolated AC//DC converters. By way of example, Fig. 1 shows the power conversion from AC to DC as a two-stage power conversion, namely as a first stage from AC to DC and as a second stage from DC to DC. However, the AC to DC power conversion may also be a one-stage power conversion. The AC network(s) connected to the IT circuit may be single phase or multi-phase. Typically, the electricity grid is a three phase network. The overall impedance between an IT circuit and PE, which may be referred to as Z_{IT-PE}, is normally of a high value, (ideally infinite) and may be considered as the Thevenin equivalent impedance value of all intended and unintended RLC components in the IT circuit, or as the result of measuring the impedance while shortening all AC phases together and the DC phases together. In practice, Z_{IT-PE} may be approximated by neglecting the differential-mode (DM) phase-to-phase impedances, since the current-mode (CM) impedance may be dominant. The insulation level of the IT circuit, and thereby the impedance value of Z_{IT-PE}, must typically be kept above a minimum value, which may be referred to as Zₘᵢₙ. It is desirable to provide a protection system for such an IT circuit. A primary function of such a protection system is to trigger a fault in case Z_{IT-PE}<Zₘᵢₙ. Such triggering of a fault may involve triggering a fault action, such as triggering a circuit braker, sending an alert, such as an external alert to alert an operator or an external system, and/or activating an auxiliary protection system.

**Fig. 2** shows a basic example of an IT circuit used for EV charging. The IT circuit comprises, from left to right, the EVSE (charger) which is represented by an impedance Z_{IT-PE(EVSE)}, wiring in the field which is represented by an impedance Z_{S}, and the EV (vehicle or vessel with battery to be charged) which is represented as an impedance Z_{IT-PE(EV)} and a battery with V_{bat}. The IT circuit comprises a DC section 101 (which is an example of a DC system as referenced elsewhere) which includes the DC part of the EVSE, the wiring in the field and the EV. The DC section may establish DC symmetry if V_{DC+} = V_{DC-} = V_{bat}/2. Such symmetry is in many applications mandatory or highly favoured for the DC section of an IT circuit. The combined impedances Z_{IT-PE(EVSE)} // Zs // Z_{IT-PE(EV)} = Z_{IT-PE}, as defined in Fig. 1 (neglecting Z_{DM}). The impedance Z_{IT-PE} represents the connection between the IT circuit and PE, and may be distributed along multiple points in the circuit. It is typically a requirement for an IT circuit that the impedance Z_{IT-PE} is high, typically > 1 MΩ.

It would be desirable to be able to monitor the symmetry of the DC section, insulation of the DC section with respect to PE, and to detect and limit fault currents towards PE. For that purpose, a protection system may be provided which may be configured for use with a symmetric DC section of an IT circuit as shown in Fig. 2.

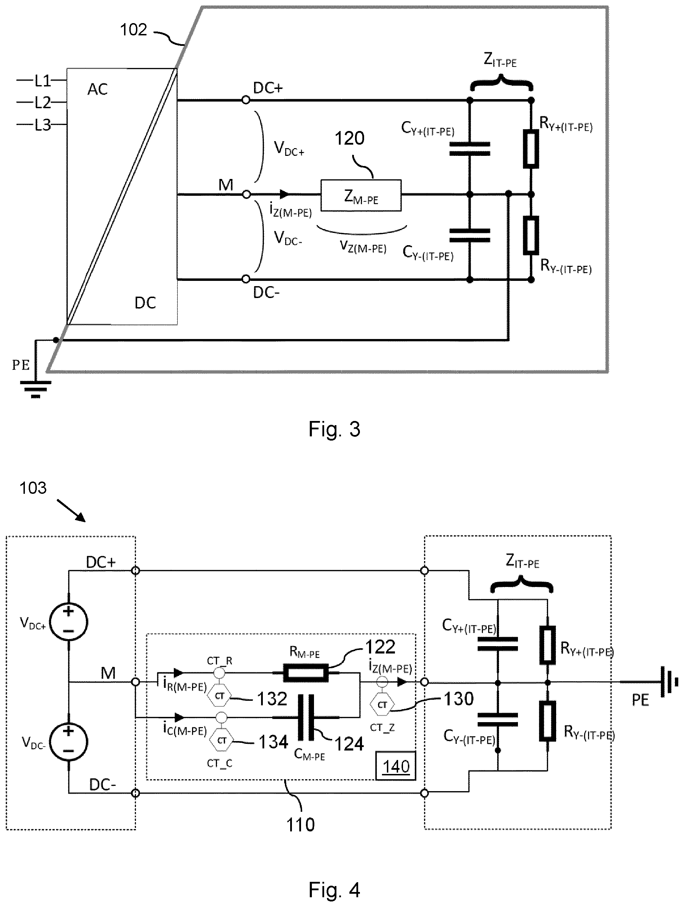

**Fig. 3** illustrates one aspect of the protection system. Namely, to detect and limit faults towards PE, a defined impedance, Z_{M-PE} may be added in between the middle-point (M) of the DC section 102 of the IT circuit, or in general the middle-point of an isolated DC system, and the PE. This way, the DC section may effectively be converted into a ZM-S circuit, as also explained elsewhere in this specification. As a result of an insulation fault towards PE, a current i_{Z(M-PE)} may flow through the impedance Z_{M-PE}. This fault current i_{Z(M-PE)} may be limited to a defined safe level, determined by the value of impedance Z_{M-PE}. The fault current i_{Z(M-PE)} may be measured, and the measured value of the fault current i_{Z(M-PE)} may be analysed by a fault detection circuit (not shown explicitly in Fig. 3) and used for protection purposes, e.g., to trigger fault actions. Inequalities between the positive-half voltage of the converter, V_{DC+}, and the negative half voltage of the converter, V_{DC-}, may be detected as this condition also causes a current circulation through Z_{M-PE}. The polarity of the current i_{Z(M-PE)} may determine whether the fault is in the positive or negative pole.

**Fig. 4** shows the protection system 110 (which may also be referred to as a protection circuit) for a DC system 103 in more detail. The protection system 110 may be composed of a combination of limiting and sensing devices that together may perform the task of monitoring a balanced symmetrical circuit, detecting imbalances, and/or limiting the fault current in case of a failure (e.g., full short or reduced IT-PE impedance below a defined threshold). In addition, the protection system 110 may act on fault current transients instead of DC voltage transients and therefore may be capable of much faster detection. The protection system is shown to comprise the aforementioned impedance Z_{M-PE} in form of a parallel arrangement of a predetermined resistance R_{M-PE} 122 and a predetermined capacitance C_{M-PE} 124. To perform the monitoring task, the fault current i_{R(M-PE)} may be measured by a current transducer 132 which may be arranged in a current path of the resistance R_{M-PE} 122. The fault current i_{R(M-PE)} is one of the currents flowing through the impedance Z_{M-PE}. By measuring the fault current i_{R(M-PE)} with the current transducer 132, DC faults and an absolute limiting current level may be measured through the resistance R_{M-PE} 122. In some embodiments, additionally or alternatively, a current transducer 134 may be provided in the current path of the predetermined capacitance C_{M-PE} 124 to measure the fault current I_{C(M-PE)}. By measuring the fault current i_{C(M-PE)} with the current transducer 134, AC currents that exhibit transient behaviour and which may be the result of stray effects and/or current mode effects may be measured through the capacitor. In some embodiments, for example as shown in Fig. 5, additionally or alternatively to the measurement of the fault current i_{R(M-PE)} and the fault current i_{C(M-PE)}, a fault current i_{Z(M-PE)} may be measured using a current transducer 130 in the common current path of the predetermined resistance R_{M-PE} 122 and the predetermined capacitance C_{M-PE} 124. By measuring the fault current i_{C(M-PE)} with the current transducer 130, it may suffice to additionally either provide the current transducer 132 or the current transducer 134 to be able to determine all three currents i_{R(M-PE)}, i_{C(M-PE)}, and i_{Z(M-PE)}. It further is noted that the fault current i_{C(M-PE)} itself may also be computed by summing i_{R(M-PE)} and i_{C(M-PE)}, thereby avoiding the need for the current transducer 130 if the current transducers 132, 134 are provided. The determination of the fault current i_{C(M-PE)} may be relevant for the compensation by a current source as also explained with reference to Fig. 5.

A fault detection circuit 140 may be provided which may have access to the one or more measured fault currents. The fault detection circuit 140 may be configured to detect an imbalance by detecting a transient or steady-state excess with respect to a defined level of current, e.g., a threshold. The value of the capacitance across R_{M-PE}, being C_{M-PE}, may determine a range of transient detection for a given application.

To allow for active regulation of the current i_{Z(M-PE)} to an intended level, in Fig. 5, a DC system 104 is shown which comprises a ZM protection circuit 112 with an added compensation current source 160. This current source 160 may be controlled, e.g., by the fault detection circuit 140, to compensate for unintended current mode (CM) stray current during normal operation and may compensate and limit the fault current in case of a failure (e.g., full short or reduced IT-PE impedance below a defined threshold). As such, the active ZM protection circuit 112 may be composed of a combination of controlling, limiting and sensing devices that together perform the task of monitoring a balanced symmetrical circuit, detecting imbalances, compensating imbalances, and/or limiting the fault current. Since the protection circuit 112 acts on fault current transients instead of DC voltage transients, it may be capable of faster compensation and detection. The compensation current source 160 may act based on i_{Z(M-PE)} as measured with current transformer 130 and may regulate i_{Z(M-PE)} to an intended value i*_{Z(M-PE)} by superimposing a current such that i_{Z(M-PE)} == i*_{Z(M-PE)}. For example, the regularization may be such that i_{Z(M-PE)} is equal or below a predetermined threshold. This threshold may, but does not need to be, equal to the fault threshold as referenced elsewhere.

With continued reference to the protection system, analogue to the IEC terminology (IEC 60364), the protection system may be considered as a ZM-S earthing system. The following definitions may be used to characterize the protection system:
o Z: defined impedance (Z) between symmetrical middle-point (M) and earth (PE).
o M: symmetrical middle-point (M) with respect to the electrical supply network. In this respect, it is noted that since there is impedance in between M and PE, the term 'neutral' cannot be used.
o S: the middle-point conductor and PE conductor are separated (S) because there is impedance in between M and PE. Unlike a neutral conductor, the middle-point conductor does not need to be provided throughout the ZM system, as shown in **Fig. 6** for a DC system 105. Therefore, the S conductor may only exist inside of the product generating M.

All converters in the ZM circuit may be connected to the symmetric DC section in a symmetrical configuration. The symmetrical middle-point (M) may be actively enforced with converter configurations or passively obtained with an impedance divider.

Typical value ranges of circuit components as shown in Fig. 4 and 5 may be as follows**Error! Reference source not found.** (here, differential mode (DM) impedances and voltage sources V_{DC} may be considered ideal):
1. R_{IT-PE} (== R_{Y+IT-PE} // R_{Y-IT-PE}): 0.1-20 MΩ (lower may be allowed depending on application requirements)
2. C_{IT-PE} (== C_{Y+IT-PE} // C_{Y-IT-PE}): 100-2000 µF (higher may be allowed depending on application requirements)
3. R_{M-PE}: 10-1000 Ω (lower may be allowed may be limited as determined by safety standard IEC 60364-4-41)
4. C_{M-PE}: 5-50 µF

It will be appreciated that the above values may be for the overall IT circuit, or at least for the overall DC section of the IT circuit. Z_{IT-PE} may be distributed over the whole IT circuit and all components within (e.g., deliberate components Z_{Y} and stray components Zs). If the protections are distributed over multiple converters, the combination of the impedances may determine Z_{IT-PE} as defined elsewhere in this specification. In the above, the converter sources may be assumed to be ideal and the midpoint (M) to lie exactly in between DC+ and DC-.

The protection system may be generally applicable to detection and limitation of fault currents and with that the protection of circuit and users. The following nevertheless provides guidance for applicability in certain domains and applications. Since the protection system may monitor the level of symmetry between 2 DC voltages, it is particularly suitable for systems in which a balanced 3-level DC voltage is used.

An exemplary application of the protection system may be one where one or more of the following is exceeded:
1. Voltage in a balanced 3-level DC voltage systems
   a. In DC charging applications, this may correspond to a voltage above HPC (> 920 V DC, IEC 61851 part 23)
      i. Within MCS, this may be the case for forced symmetry circuits (mandatory for V_{DC}> 920 V DC and allowed below that value)
      ii. Above the voltages listed in *Table 1* below always mandatory.
2. High system level Y-capacitance value
   a. In DC charging applications, the Y-capacitance value may be limited per power level as listed in *Table 1.*
3. Fault detection time with other protection means exceeds that defined per standard
   a. In DC charging applications, detection times exceeding the values in *Table 1.*
4. In the application of charging, this is typically the case for systems of 1 MW and above.

**Table 1 IEC 61851 - limit values per part (time and C_{Y} per respective side EVSEIEV)**

| ** According to ISO 6469*, *@VDCmax. Other EV side safety standards may be leading; however principle remains applicable.* | | | | | |
|---|---|---|---|---|---|
| **Part** | **Max power [kW]** | **tₗᵢₘ [s]** | **V_{DC} max [V]** | **C_{Y-EVSE} [µF]** | **C_{Y-EV} [µF]** |
| 23 | 560 | 10 | 920 | 1 | 0,47* |
| 23-1 | 1000 | 10 | 1000 | 4 | 0,4* |
| 23-3 | 3750 | 60 | 1000 | 15 | 15 |
| | | | 1200 | 8 | 8 |
| | | | 1250 | 5 | 5 |

**Fig.** Error! Reference source not found.**7** illustrates three examples of fault situations that may be detected, limited and discriminated by the ZM protection circuit. These fault situations may be referred to as fault 1, 2, and 3, and their fault resistances as R_{fault1}, R_{fault2}, and R_{fault3}:
Fault point 1: R_{fault1} is the fault resistance value in between DC+ and PE
Fault point 2: R_{fault2} is the fault resistance value in between DC- and PE
Fault point 3: R_{fault3} is the fault resistance value in between any of the AC terminals of non-insulated equipment in the ZM circuit and PE.

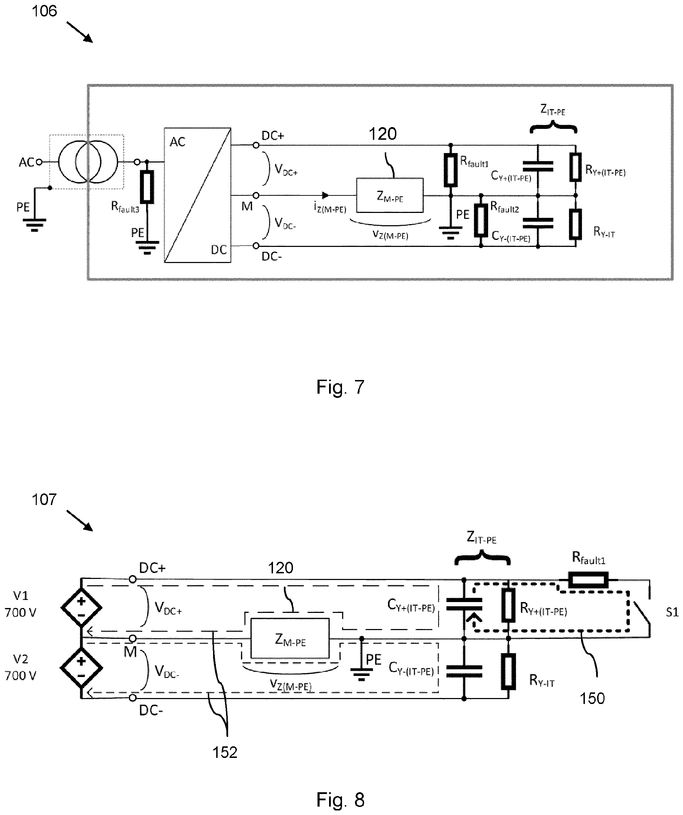

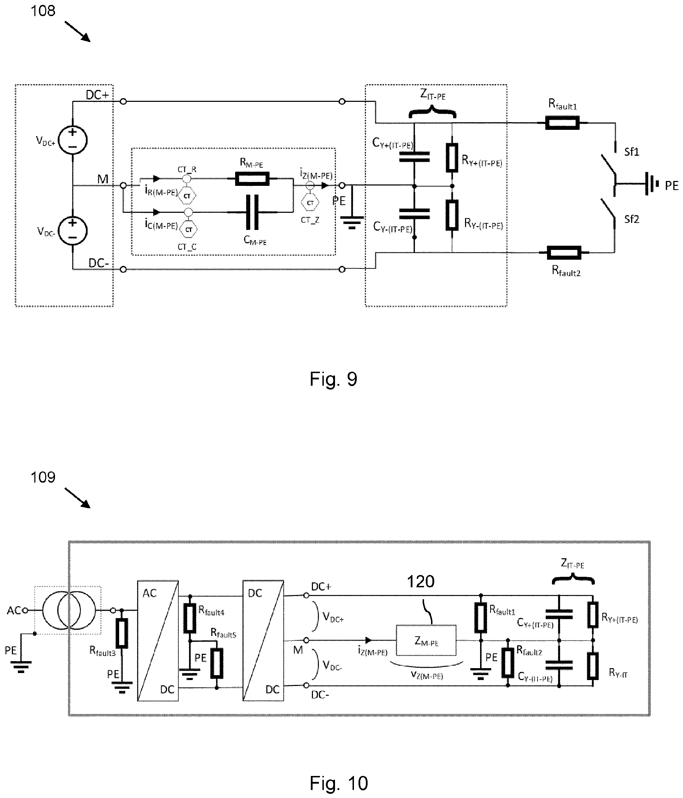

In general, a possible fault (R_{fault1/2/3}) may be limited through R_{M-PE} since the latter may provide a limiting effect for the fault current caused by the discharge of:
Rfault1: In **Fig. 8****,** an example is shown of fault 1 with main fault current path 150 and detection fault current path 152 through Z_{M-PE}. It can be seen that C_{Y+(IT-PE)} may be discharged via R_{fault1} and R_{M-PE} based on the ratio between both resistances. **Error! Reference source not found.** V_{DC+} may be pulled down toward PE level by closing S1 and conduction through R_{fault1}. As a result, the approximated voltage across R_{M-PE} becomes V_{DC+} resulting in a current through R_{M-PE} in indicated direction leading to a negative i_{Z(M-PE)}**Error! Reference source not found..**
Rfault2: C_{Y-(IT-PE)} discharge. Situation equal to fault 1 but with currents in reversed direction and resulting in a positive i_{Z(M-PE)}. See also **Fig. 9** which shows the switch S2 and C_{Y-(IT-PE)} between the negative pole DC- and PE.
Rfault3: coupling of the fault to the DC lines via the converter and with that C_{Y+(IT-PE)} and/or C_{Y-(IT-PE)}, respectively.

In general, from the polarity of i_{Z(M-PE)}, e.g., the sign thereof, it may be determined whether fault 1 (negative sign) or fault 2 (positive sign) occurs. Based on i_{R(M-PE)}, the ratio between R_{fault} and R_{M-PE} may be determined, and with that R_{fault} may be derived (neglecting R_{Y} since that will typically be of much higher value). In a fault condition (e.g., after a transient time of around 3 times the time constant defined by R_{M-PE} times C_{M-PE}), the measured current i_{R(M-PE)} may be given by (here, x may refer either to fault 1, 2, or 3) i_{R(M-PE)} = V_{DCx}/(R_{faultx} + R_{M-PE}). As the value of R_{M-PE} may be predetermined and the voltages V_{DC+} and V_{DC-} (commonly termed V_{DCx}) may also be known or measured, the fault resistance value may be determined by R_{faultx} = (V_{DCx}/i_{R(M-PE)}) - R_{M-PE}. Or in other words, one may solve for R_{fault} in the formula i_{R(M-PE)} = V_{DC}/(R_{fault} + R_{M-PE}), where V_{DC} is a DC voltage at the respective positive or negative conductor.

**Fig. 10** shows additional fault locations and may be explained as follows. When a fault condition to PE is experienced at the AC side (represented by the R_{fault3} in Fig. 10 but which may occur with respect to any of the AC phases), this typically causes also an imbalance in the operation of the DC section, as the AC/DC power converter has no isolation and its internal active or passive switches (semiconductors power components like IGBTs or diodes), due to their conduction action, connect alternately the DC side (DC+ or DC- terminals) to the AC side, which in turn causes a current to flow through the impedance Z_{M-PE} 120. By measuring the current, such AC fault currents through R_{fault3} may be detected in a similar way as explained for the DC side. Namely, by measuring the magnitude of the current i_{Z(M-PE)} and comparing it against a threshold, the severity of the fault may be determined. In particular, in case of an PE fault at the AC side, the fault current i_{Z(M-PE)} may contain AC components that may be detected by the fault protection circuit of the protection system. If such AC components are detected, the fault protection circuit may conclude that the current i_{Z(M-PE)} is at least in part due to a fault condition to PE at the AC side.

By way of example, Fig. 10 shows the power conversion from AC to DC as a two-stage power conversion, namely as a first stage from AC to DC and as a second stage from DC to DC. In such a two-stage power conversion, there may be fault condition to PE at the DC input side of the second stage, represented by R_{fault4} and R_{fault5} in Fig. 10. Such fault conditions also typically cause an imbalance in the DC output side which again may cause a current to flow through the impedance Z_{M-PE} 120. By measuring the current, such fault currents through R_{fault4} and R_{fault5} may be detected in a similar way as previously explained for R_{fault1} and R_{fault2}, namely by measuring the magnitude and direction of the current i_{Z(M-PE)}.

In general, the above-described protection system may be used as an IT circuit grounding method for DC systems with (high) capacitances to protective earth. In particular, the protection system may be used for monitoring, detecting and limiting of fault current in a symmetric IT circuit. The protection system may further help in voltage balancing and may limit ground fault currents to safe values with fast detection for protection against safety ground faults on DC and AC sides. The detection may be fast, for example typically 100 ms, in comparison to currently used IMD devices (10-60 seconds) since i_{Z(M-PE)} is used to detect a fault instead of an indirect RC estimation. For the protection, there is no limitation in the allowed maximum IT circuit Y-capacitance value. Similarly to an IMD, the protection system may detect a too low R_{IT-PE} value based on the magnitude of the fault current. The protection system may further detect and limit permanent values of short-circuit of DC+ or DC- to PE, detect voltage imbalance in DC sections, and limit value of short-circuit current to predetermined values. The protection system may represent a passive method, free of injecting signal, that does not cause any interference or disturbance in the monitored DC system. The protection system may be deployed centrally to detect faults everywhere in the IT circuit, not only in the (symmetric) DC part of the system.

The protection system may comprise one or more (micro)processors which execute appropriate software and which may implement certain functionality of the protection system, specifically the functionality of the fault detection circuit. The software may have been downloaded and/or stored in a corresponding memory or memories, e.g., in volatile memory such as RAM or in non-volatile memory such as Flash. Alternatively, the fault detection circuit may be implemented in the form of programmable logic, e.g., as a Field-Programmable Gate Array (FPGA).

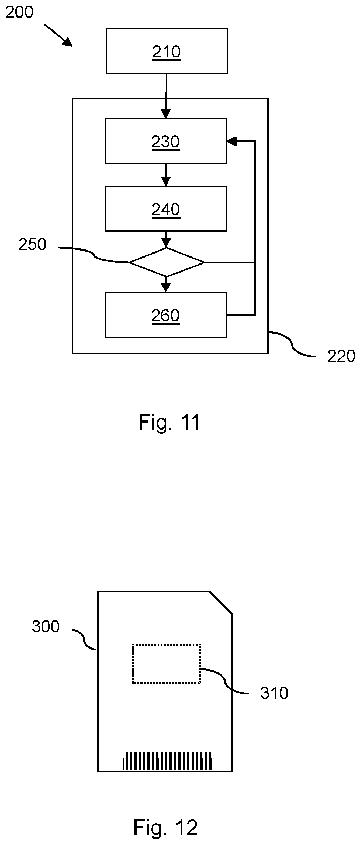

**Fig. 11** shows a protection method 200 for a symmetric, isolated terra bipolar DC system. The method 200 may comprise providing 210 a predetermined impedance between the midpoint conductor and protective earth, and during operation 220 of the DC system, determining 230 a current flowing through at least a resistive part of the predetermined impedance, determining 240 a magnitude of the current, comparing 250 the magnitude of the current against a threshold, and triggering 260 a fault action if the magnitude of the current exceeds the threshold. For example, the threshold may be chosen for human protection, for example as defined in IEC 60479-1 Part 1 with reference to the effects of current on human beings and livestock. Another example is that the threshold may be chosen in accordance with automotive industry standards, for example as 10 mA as defined by SAE J1766 for continuous monitoring.

Select steps of methods described in this specification, for example in any of the claims, may be implemented on a computer as a computer implemented method, as dedicated hardware, or as a combination of both. Instructions for the computer, e.g., executable code, may be stored on a computer-readable medium 300 as for example shown in **Fig. 12****,** e.g., in the form of a series 310 of machine-readable physical marks and/or as a series of elements having different electrical, e.g., magnetic, or optical properties or values. The executable code may be stored in a transitory or non-transitory manner. Examples of computer-readable mediums include memory devices, optical storage devices, integrated circuits, etc. **Fig. 12** shows a memory card 300.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim. Use of the verb "comprise" and its conjugations does not exclude the presence of elements or stages other than those stated in a claim. The article "a" or "an" preceding an element does not exclude the presence of a plurality of such elements. Expressions such as "at least one of" when preceding a list or group of elements represent a selection of all or of any subset of elements from the list or group. For example, the expression, "at least one of A, B, and C" should be understood as including only A, only B, only C, both A and B, both A and C, both B and C, or all of A, B, and C. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. A protection system (110) for a DC system, wherein the DC system is an isolated terra bipolar DC system comprising a positive conductor, a negative conductor, and a midpoint conductor, wherein the DC system is designed to be symmetric around a midpoint at the midpoint conductor, wherein the protection system comprises:
- a predetermined impedance (120) arranged between the midpoint conductor and protective earth;
- a current measurement circuit (130-134) configured to determine a magnitude of a current flowing through at least a resistive part of the predetermined impedance;
- a fault detection circuit (140) configured to compare the magnitude of the current against a threshold, and to trigger a fault action if the magnitude of the current exceeds the threshold.

2. The protection system (110) according to claim 1, wherein the current measurement circuit is further configured to determine a direction of the current, and the fault detection circuit is configured to, on the basis of the direction, determine a fault location of an isolation fault with respect to the protective earth.

3. The protection system (110) according to claim 1 or 2, wherein the fault action comprises one or more of:
- triggering a circuit braker;
- sending an alert to an external entity; and
- activating an auxiliary protection system.

4. The protection system (110) according to any one of claims 1 to 3, wherein the impedance (120) comprises or consists of a parallel arrangement of a predetermined resistance (122) and a predetermined capacitance (124).

5. The protection system (110) according to claim 4, wherein the current measurement circuit (130-134) comprise at least two of: a current transducer (132) arranged in a current path of the predetermined resistance (122), a current transducer (134) arranged in a current path of the predetermined capacitance (124), and a current transducer (130) arranged in a common current path of the predetermined resistance (122) and the predetermined capacitance (124).

6. The protection system (110) according to claim 5, wherein the fault detection circuit (140) is configured to determine a resistance R_{fault} of an isolation fault between on the one hand the positive conductor or the negative conductor and on the other hand the protective earth by solving for R_{fault} in the formula i_{R(M-PE)} = V_{DC}/(R_{fault} + R_{M-PE}), where i_{R(M-PE)} is a value of a measured current through the predetermined resistance (122), R_{(M-PE)} is a value of the predetermined resistance, and V_{DC} is a DC voltage at the respective positive or negative conductor.

7. The protection system (110) according to any one of claims 4 to 6, wherein the predetermined resistance (122) is chosen from a range of 10-1000 Ω.

8. The protection system (110) according to any one of claims 4 to 7, wherein the predetermined capacitance (124) is chosen from a range of 5-50 µF.

9. The protection system (110) according to any one of claims 1 to 8, further comprising a current source (160) arranged in a current path of the predetermined impedance (120), wherein the fault detection circuit (140) is configured to control the current source to reduce the current flowing through the predetermined impedance.

10. A DC system (101-104, 106, 107) in form of an isolated terra bipolar DC system, wherein the DC system comprises a positive conductor, a negative conductor, and a midpoint conductor, wherein the DC system is designed to be symmetric around a midpoint at the midpoint conductor, wherein the DC system comprises the protection system (110) according to any one of claims 1 to 9.

11. The DC system (101-104, 106, 107) according to claim 10, wherein the DC system is designed to comprise a system resistance between i) each one of the positive conductor and the negative conductor and ii) protective earth, wherein the system resistance is within a range of 0.1-20 MΩ.

12. The DC system (101-104, 106, 107) according to claim 10 or 11, wherein the DC system is designed to comprise a system capacitance between i) each one of the positive conductor and the negative conductor and ii) protective earth, wherein the system resist capacitance is within a range of 100-2000 µF.

13. The DC system (101-104, 106, 107) according to any one of claims 10 to 12, wherein the DC system is or comprises a DC charger, for example an EV DC charger.

14. The DC system (101-104, 106, 107) according to any one of claims 10 to 13, wherein the DC system is configured to operate as a symmetrical DC system at a maximum DC voltage at or above 920 V.

15. A protection method (200) for a DC system, wherein the DC system is an isolated terra bipolar DC system comprising a positive conductor, a negative conductor, and a midpoint conductor, wherein the DC system is designed to be symmetric around a midpoint at the midpoint conductor, wherein the protection method comprises:
- arranging (210) a predetermined impedance between the midpoint conductor and protective earth;
and during operation of the DC system:
- determining (230) a current flowing through at least a resistive part of the predetermined impedance;
- determining (240) a magnitude of the current;
- comparing (250) the magnitude of the current against a threshold; and
- triggering (260) a fault action if the magnitude of the current exceeds the threshold.
